# EUROPEAN PATENT APPLICATION

(11) **EP 4 290 249 A1**
(43) Date of publication of application: **13.12.2023**
(21) Application number: 22177972.1
(22) Date of filing: 08.06.2022
(51) Int. Cl.: G01R 31/00, B60L 3/00, B60L 53/16

(54) **DIAGNOSTICS FOR ELECTRICAL CAR**

(71) Applicant: Schneider, Thorsten, 71065 Sindelfingen (DE); Huang, Shifang, 71065 Sindelfingen (DE)
(72) Inventor: Schneider, Thorsten, 71065 Sindelfingen (DE); Huang, Shifang, 71065 Sindelfingen (DE)
(74) Representative: Wittmann, Günther

(57) **Abstract**

The invention discloses a method of diagnosing an electric component of an electric vehicle comprising a high voltage traction battery and a charging connector coupled with the high voltage traction battery, comprising the following steps:
- connecting a vehicle test apparatus with the charging connector of the electric vehicle by a test cable;
- verifying the at least one electric component of the electric vehicle;
wherein the step of verifying comprises the following step:
- receiving the monitoring signal of the electric component at the vehicle test apparatus, wherein the monitoring signal is transmitted via the charging connector and the test cable; or comprises the following two steps:
- transmitting a test input signal from the vehicle test apparatus via the test cable and the charging connector to the electric component of the electric vehicle; receiving the monitoring signal of the electric component responsive to the test input signal at the vehicle test apparatus, wherein the monitoring signal is transmitted via the charging connector and the test cable and
- analyzing the monitoring signal at the vehicle test apparatus.

## Description

### Field of the Invention

The present invention relates to diagnostics of an electric vehicle, particularly to diagnostics that can be carried out with a low effort.

### Prior Art

Diagnostics of electric vehicles such as full electric vehicles or plugin hybrid vehicles require a so-called breakout box. For each vehicle type a different breakout box is required. This breakout box must be designed for the high voltage of a vehicle traction battery such as approximately 400 V to approximately 800 V. Further, specialized experts are required for operating a breakout box.

Currently it is not possible to carry out impedance and spectrum analysis on the high voltage, since breakout boxes of the prior art cannot provide sufficient galvanic isolation.

It is an object of the present invention to overcome the limitations of prior art diagnostics equipment.

### Summary of the invention

It is an object of the present invention to provide an improved method of diagnostics and an improved vehicle test apparatus that diagnoses an electric vehicle.

The object of the present invention is achieved by a method according to claim 1, a vehicle test apparatus according to claim 8 and an electric vehicle according to claim 15. The depending claims are directed to preferred embodiments.

An electric vehicle to be diagnosed comprises a high voltage traction battery, an electric motor, an inverter and a charging connector coupled with the high voltage traction battery. Design and operation of an electric vehicle are known to the person skilled in the art and do not have to be explained in further detail herein.

A first embodiment of a method according to the present invention for diagnosing an electric component of an electric vehicle comprises the step of connecting a vehicle test apparatus with the charging connector of the electric vehicle by a test cable. The method further comprises the step of receiving a monitoring signal of the electric component of an electric vehicle at the vehicle test apparatus. The monitoring signal is transmitted via the charging connector and the test cable. The method further comprises the step of analyzing the monitoring signal at the vehicle test apparatus.

A second embodiment of a method according to the present invention for diagnosing an electric component of an electric vehicle comprises the step of connecting a vehicle test apparatus with the charging connector of the electric vehicle by a test cable. A test input signal is transmitted from the vehicle test apparatus via the test cable and the charging connector to the electric component of the electric vehicle. The method further comprises the step of receiving a monitoring signal of the electric component responsive to the test input signal at the vehicle test apparatus. The monitoring signal is transmitted via the charging connector and the test cable. The method further comprises the step of analyzing the monitoring signal at the vehicle test apparatus.

The object of the present invention is also solved by a method of diagnosing an electric component of an electric vehicle comprising a high voltage traction battery and a charging connector coupled with the high voltage traction battery, comprising the steps of connecting a vehicle test apparatus with the charging connector of the electric vehicle by a test cable and verifying the at least one electric component of the electric vehicle. The step of verifying may comprise the step of receiving a monitoring signal of the electric component at the vehicle test apparatus, wherein the monitoring signal is transmitted via the charging connector and the test cable. Alternatively or additionally, the step of verifying may comprise the steps of transmitting a test input signal from the vehicle test apparatus via the test cable and the charging connector to the electric component of the electric vehicle and receiving the monitoring signal of the electric component responsive to the test input signal at the vehicle test apparatus, wherein the monitoring signal is transmitted via the charging connector and the test cable. The method analyzing the monitoring signal at the vehicle test apparatus.

The battery may be part of the HV-power net. The test cable may be a conventional charging cable.

According to the present invention, a test input signal is transmitted via the charging connector of the electric vehicle and the response signal from at least one electric component of the electric vehicle is received as a monitoring signal by the vehicle test apparatus. The present invention has the advantage, that no breakout box is required and that the present invention may be operated by non-expert staff.

The test input signal may be an impedance measurement signal, and/or an insulation measurement signal. The impedance measurement signal may be generated by a network analyzer that can measure the impedance of the electric component of the electric vehicle. The impedance may be determined in a frequency range of approximately 10 Hz to approximately 500 kHz. The impedance of an electric component is an important characteristic and should not change during the lifecycle of an electric vehicle.

The monitoring signal comprises an impedance measurement signal; a spectrum analysis signal and an isolation measurement signal.

The spectrum analysis may be performed by a spectrum analyzer. Such spectrum analyzer may analyze voltage and current of an electric component, such as a high voltage electric component. Such spectrum analyzer may operate conformant to ISO21498. Such spectrum analyzer provides a comparably simple check of an electric component.

The isolation measurement signal can be applied between the HV+ pin and HV- pin, between the HV+ pin and earth as well as between the HV- pin and earth.

The method may comprise the step of supplying charging current for charging the high voltage traction battery of the electric vehicle to the charging connector, wherein the charging current flows through the test cable. Consequently, a charging controller of the electric vehicle assumes that the high voltage traction battery is charged and close all switches, which are necessary for charging the high voltage traction battery. Consequently, the vehicle test apparatus can diagnose the high voltage system of the electric vehicle.

The method may comprise before the step of supplying charging current the step of transmitting a charging request command from the vehicle test apparatus via the test cable and the charging connector to the charging controller of the vehicle. The electric vehicle performs the step of closing at least one charging switch of the electric vehicle responsive to the charging request command under control of the charging controller. The charging switch connects at least one pin of the charging connector with the high voltage traction battery of the electric vehicle. After detecting at the vehicle test apparatus that charging current flows through the test cable, the verifying the at least one electric component of the electric vehicle is executed.

In one embodiment, the method may comprise the step of transmitting a charging request command from the vehicle test apparatus via the test cable and the charging connector to the charging controller of the electric vehicle. The at least one charging switch of the electric vehicle is closed responsive to the charging request command under control of the charging controller. The charging switch connects at least one pin of the charging connector with the high voltage traction battery of the electric vehicle. After detecting at the vehicle test apparatus that charging current flows through the test cable for a predetermined time span, the method stops in this embodiment the charging current from the vehicle test apparatus to the test cable by opening a charging switch in the vehicle test apparatus. Thereafter the step of verifying the at least one electric component of the electric vehicle is performed. In this embodiment, the at least one electric component of the electric vehicle is verified after a so-called load dump.

In one embodiment, the vehicle test apparatus may be connected to a predetermined electric component of the electric vehicle. Therefore, the steps described in the following are executed before the step of verifying the at least one electric component of the electric vehicle. A connection request is transmitted from the vehicle test apparatus to a vehicle diagnosis controller via the test cable. The connection request signal requests that the vehicle test apparatus is to be connected to the predetermined component of the electric vehicle. The vehicle diagnosis controller connects at least one pin of the charging connector with the predetermined component of the electric vehicle. Thereby, an arbitrary electric component of the electric vehicle may be diagnosed, such as an air-conditioning system, a motor or the like.

In one embodiment, the vehicle test apparatus may request that the predetermined component is switched into a predetermined status. For example, the air conditioner that may be switched in the status heating or cooling. Therefore, the method executes the step described in the following before the step of verifying the at least one electric component of the electric vehicle. A status change request signal is transmitted from the vehicle test apparatus to the vehicle diagnosis controller via the test cable and the charging connector. The status change request signal requests that the predetermined component of the electric vehicle is switched into a predetermined status and the vehicle diagnosis controller switches the predetermined component of the electric vehicle in the predetermined status.

Thereby, the electric component of the electric vehicle may be diagnosed during its operation, such as, when the air-conditioner is cooling, when the air-conditioning is heating, when a motor is accelerating the vehicle, if the vehicle is located on a roller dynamometer.

The invention also discloses a vehicle test apparatus for diagnosing an electric component of an electric vehicle comprising a high voltage traction battery and a charging connector coupled with the high voltage traction battery. The vehicle test apparatus comprises a cable connection element adapted that a test cable can be connected thereto. The test cable comprises a test plug that can be coupled to a charging connector of the electric vehicle. The cable connection element may be a plug, in which a connector of the test cable may be placed. The term cable connection element may also comprise that the test cable is fixed to the vehicle test apparatus. The vehicle test apparatus may further comprise a transmitter adapted to transmit a test input signal via the test cable and the charging connector to the electric component of the electric vehicle. The vehicle test apparatus comprises a receiver adapted to receive a monitoring signal of the electric component responsive to the test input signal. The monitoring signal is transmitted via the charging connector and the test cable to the receiver of the vehicle test apparatus. The vehicle test apparatus may comprise an analyzer adapted to analyze the monitoring signal.

The object of the invention is also achieved by a vehicle test apparatus for diagnosing an electric component of an electric vehicle comprising a high voltage traction battery and a charging connector coupled with the high voltage traction battery comprising a cable connection element adapted that a test cable can be connected thereto, wherein the test cable comprises a test plug that can be coupled to a charging connector of the electric vehicle, a first controller adapted to verify at least one electric component of the electric vehicle, a transmitter adapted to transmit a test input signal via the test cable and the charging connector to the electric component of the electric vehicle, a receiver adapted to receive a monitoring signal of the electric component responsive to the test input signal, wherein the monitoring signal is transmitted via the charging connector and the test cable; and an analyzer adapted to analyze the monitoring signal. The first controller is further adapted for verifying at least one electric component of the electric vehicle to instruct the receiver to receive a monitoring signal of the electric component responsive to the test input signal, wherein the monitoring signal is transmitted via the charging connector and the test cable or adapted to instruct a transmitter to transmit a test input signal via the test cable and the charging connector to the electric component of the electric vehicle and to instruct the receiver to receive a monitoring signal of the electric component responsive to the test input signal, wherein the monitoring signal is transmitted via the charging connector and the test cable.

The test input signal may comprise an impedance measurement signal, and/or an isolation measurement signal.

The monitoring signal comprises an impedance measurement signal; a spectrum analysis signal and an isolation measurement signal.

The vehicle test apparatus may be configured as described above with respect to the method.

The vehicle test apparatus may comprise a charging device adapted to supply a charging current to the charging connector of the electric vehicle to charge the high voltage traction battery. The charging current flows through the test cable.

The vehicle test apparatus may comprise a first test controller adapted to transmit a charging request command via the test cable and the charging connector to a charging controller of the electric vehicle. The charging controller of the electric vehicle is adapted to close at least one charging switch of the electric vehicle responsive to the charging request command. The charging switch connects at least one pin of the charging connector with the high voltage traction battery of the electric vehicle. The first test controller is further adapted to transmit the test input signal from the vehicle test apparatus via the test cable and the charging connector to the electric component of the electric vehicle, after the first test controller detected that charging current flows through the test cable.

In one embodiment the first test controller is further adapted to transmit a charging request command via the test cable and the charging connector to the charging controller of the electric vehicle. The charging controller of the electric vehicle is adapted to close at least one charging switch of the electric vehicle responsive to the charging request command. The charging switch connects at least one pin of the charging connector with the high voltage traction battery of the electric vehicle. The first test controller is further adapted to stop the charging current flow from the vehicle test apparatus to the test cable by opening a charging switch of the vehicle test apparatus, after the first controller of the vehicle test apparatus detected that charging current flows through the test cable for a predetermined time span. Then, the first controller instructs to verify the at least one electric component of the electric vehicle. In this embodiment, the at least one electric component of the electric vehicle is verified after a load dump.

The vehicle test apparatus may comprise a second test controller adapted to transmit a connection request signal to a vehicle diagnosis controller via the test cable, wherein the connection request signal requests that the vehicle test apparatus is to be connected to a predetermined electric component of the electric vehicle. The vehicle diagnosis controller connects at least one pin of the charging connector with the predetermined component of the electric vehicle. The vehicle diagnosis controller connects at least one pin of the charging connector with the predetermined component of the electric vehicle. The second test controller is further adapted to instruct to verify the at least one electric component of the electric vehicle.

The second test controller may be adapted to transmit a status change request signal to the vehicle diagnosis controller via the test cable. The status change request signal requests that the predetermined component of the electric vehicle is switched into a predetermined status. The vehicle diagnosis controller is adapted to switch the predetermined component of the electric vehicle in the predetermined status.

The invention also discloses an electric vehicle comprising a high voltage traction battery, a charging connector that can be connected with the high voltage traction battery and at least one further electric component. The electric vehicle further comprises a vehicle diagnosis controller adapted to, after receiving a connection request signal at at least one pin of the charging connector, to control at least one diagnosis switch, such, that at least one pin of the charging connector is connected with the at least one further electric component.

### Brief description of the drawings

The invention is now explained in further detail with reference to exemplary and nonlimiting embodiments, wherein
Figure 1 shows a schematic overview of electric component of the electric vehicle;
Figure 2 shows a schematic alley use of the vehicle test apparatus according to the present invention;
Figure 3 shows more details of the test set up of figure 2;
Figure 4 shows more details of a test device;
Figure 5 shows a schematic of the present invention; and
Figure 6 shows a block diagram of a diagnosis controller.

### Detailed description of the invention

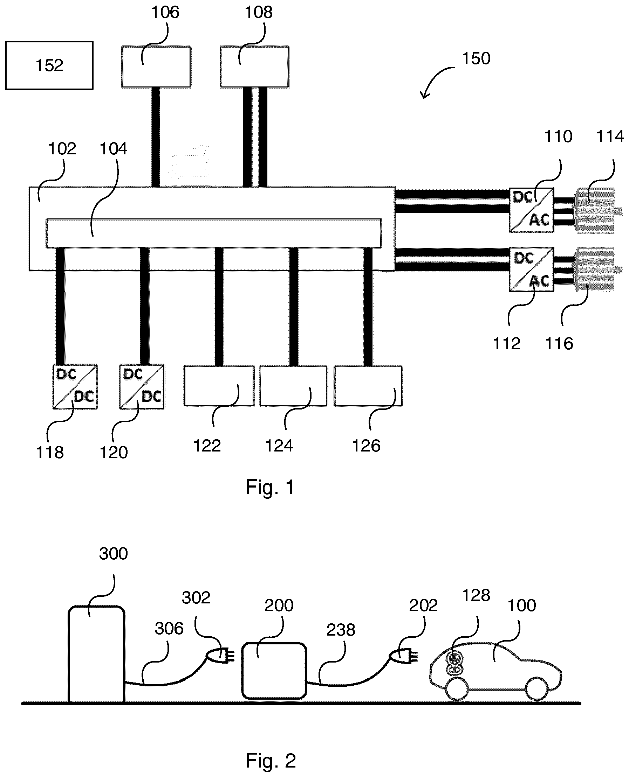

The person skilling the art knows how an electric vehicle is designed. Figure 1 shows a schematic view of components of high voltage equipment 150 of an electric vehicle 100 (see figure 2). The high voltage equipment 150 may be at least a part of a high voltage power-net or the high voltage power-net.

The electric vehicle 100 comprises a high voltage battery 102 that may have a voltage of 400 V or 800 V. The battery 102 is connected to a high voltage distributor 104. An AC charger 106 and a DC charger 108 are connected to the high voltage battery 102. Charging of the battery 102 is controlled by the charging controller 152.

To the high voltage distributor 104 a first DC/DC converter is connected that supplies a 12 V grid of the electric vehicle 100. A second DC/DC converter 120 is connected to the high voltage distributor 104 that supplies a 48 V grid of the electric vehicle 100. Further, a compressor 122 of the air-conditioner, a heating 124 and a pump 126 are connected to the high voltage distributor 104.

A first electric traction motor 114 is connected by a first inverter 110 with the high voltage battery 102, and a second electric traction motor 116 is connected via an inverter 112 with the high voltage battery 102.

The components of the electrical vehicle may be voltage class B components.

Figure 2 shows a schematically use of a vehicle test apparatus 200 according to the present invention. The test apparatus 200 comprises a test cable 238 to which a test plug 202 is connected. The test plug 202 may be connected to a vehicle charging inlet 128 of the electric vehicle 100. An electric vehicle supply equipment 300 may be connected by a charging cable 306 and a charging connector 302 with a connector (not shown) of the vehicle test apparatus 200 for supplying charging current. In one embodiment the vehicle charging inlet 128 may be the DC charging connector.

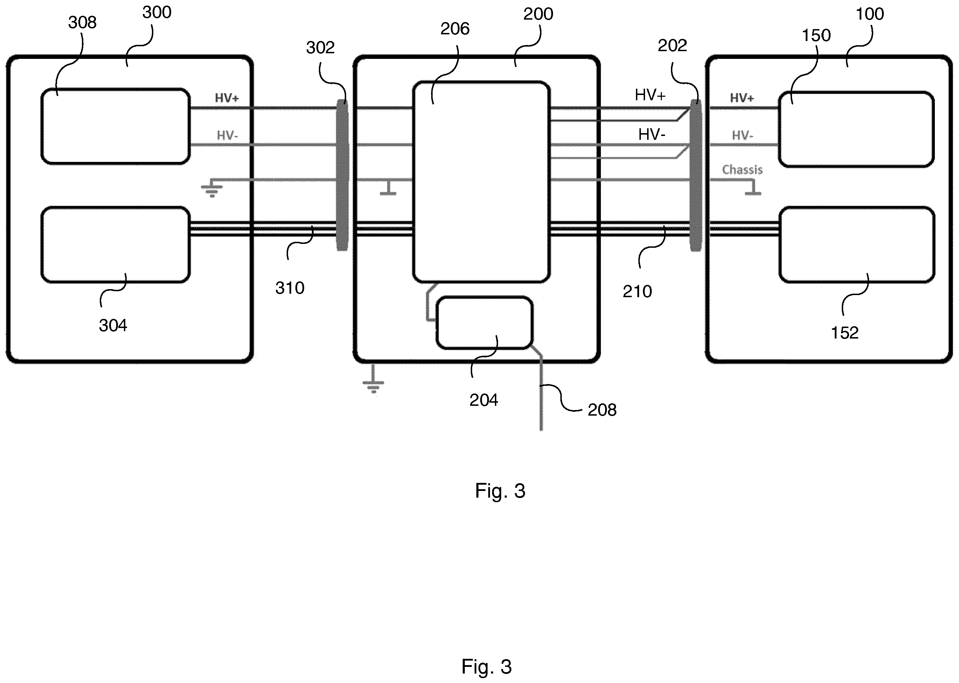

Figure 3 shows more details of the test set up of figure 2. The optional electric vehicle supply equipment 300 comprises a high voltage power supply 308 and a charging controller 304. The high voltage power supply supplies DC current via the lines HV+ and HV- to the charging plug 302, which is supplied to the vehicle test apparatus 200. The charging controller 304 communicates by control lines 310 with the vehicle test apparatus 200, wherein the control lines are supplied by the connector 302 to the vehicle test apparatus 200. The HV+ line, the HV- line, ground and the first control lines 310 may be part of a conventional charging cable.

The vehicle test apparatus 200 comprises a test device 206 to which the HV+ line, the HV- line, ground and the first control lines 310 are connected. The vehicle test apparatus 200 further comprises a diagnosis controller 204 connected to and controlling the test device 206. The diagnosis controller 204 comprises an interface 208 for transmitting control data to the diagnosis controller 204 and for receiving a test data from the diagnosis controller 204. The diagnosis controller 204 may be any suitable controller such as a personal computer, a programmable logic controller, an FPGA or the like. The interface 208 may comprise a USB interface for transmitting and receiving data.

The test device 206 is connected by two HV+ lines with a HV+ port of the test plug 202 and by two HV- lines with the HV- pin of the plug 202. The test device 206 may be connected by second control lines 210 with the PP pin, CP pin, and PE pin of the test plug 202. The PE line may be directly coupled from the charging controller 152 to the PE pin of the test plug 202 and with the chassis of the electric vehicle 100.

The electric vehicle 100 comprises a high voltage equipment 150 that is connected to the HV+ pin and HV- pin of the test plug 202. The high voltage equipment 150 may be a high voltage powernet and/or high voltage system. The electric vehicle 100 further comprises a charging controller 152 connected to PP pin, PE pin and CP pin of the plug 202.

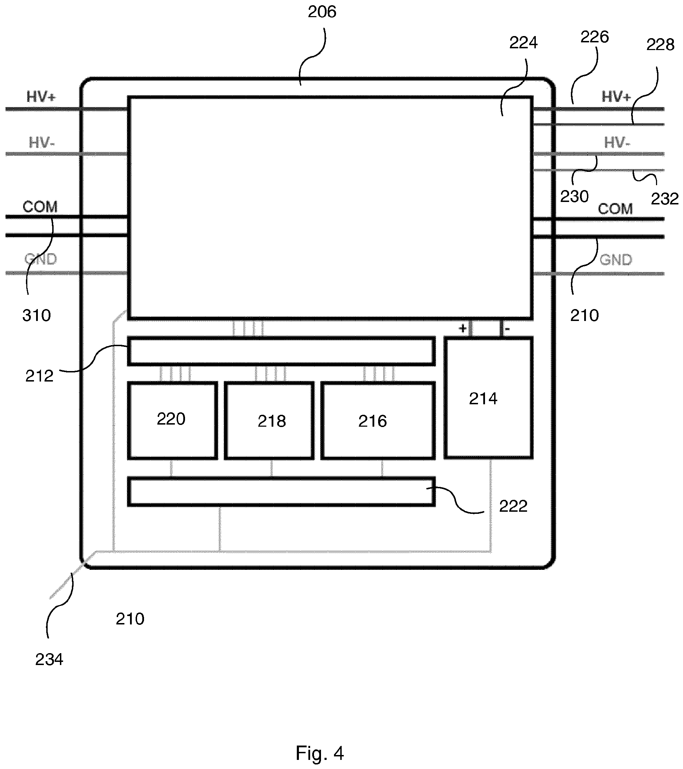

Figure 4 shows more details of the test device 206. The test device 206 comprises a test circuit 224 to which the HV+ input line the HV minus input line, the first control lines 310 and the ground from the electric vehicle supply equipment 300 are connected. To the test circuit 224 two HV+ output lines 226, 228, two HV- output lines 230, 232, second control lines 210 and ground are connected. The second control lines 210 may comprise the PE line for grounding purposes.

The test device 206 further comprises an optional galvanic separation 212 connected between the test circuit 224 and a network analyzer 220, a spectrum analyzer 218 as well as an insulation measurement device 216. The test device 206 further comprises a high voltage power supply 214 that can supply power for the HV+ and HV- lines. The HV power supply allows to supply HV+ and HV- current without use of the electric vehicle supply equipment 300. The optional galvanic separations 212, 222 allow proper separation of a high voltage section and a low voltage section in the test device 206.

The test device 206 further comprises a control and data interface 234 connected to the test circuit 224, the high voltage power supply 214, the network analyzer 220, the spectrum analyzer 218 and the insulation measurement device 216. An optional galvanic separation 222 may be interconnected between the network analyzer 220, the spectrum analyzer 218, the insulation measurement device on the one hand and the controller and data interface 234 on the other hand.

The isolation measurement device 216 is adapted to measure the isolation between HV+ and HV-, HV+ and ground, as well as HV- and ground.

The network analyzer 220 may determine the impedance of the high voltage board net, such as the high voltage powernet in the electric vehicle 100. The impedance of the high voltage board net may be determined in a frequency range from approximately 10 Hz to approximately 500 kHz. The impedance is an important characteristic of the high voltage board net and shall be more or less constant during the lifespan of an electric vehicle 100. By the spectrum analyzer 218 the voltage and current can be analyzed in the frequency range. Such spectrum analysis may be performed in accordance to ISO 21498. The spectrum analyzer 218 allows an appropriate check of the behavior of voltage and current of the high voltage board net of the electric vehicle 100.

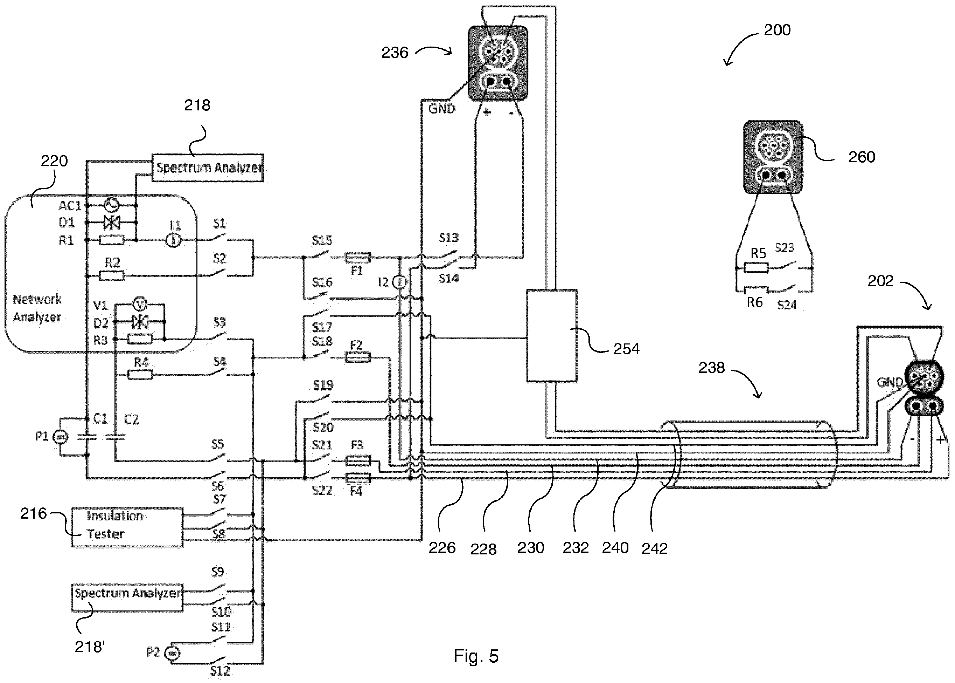

Figure 5 shows a schematic of the vehicle test apparatus 200 according to the present invention. The charging current may flow from a diagnosis charging inlet 236 to the test plug 202, if a thirteenth switch S13 and a fourteenth switch S14 are closed. The thirteenth switch S13 is connected between the HV- pin of the diagnosis charging inlet 236 and the second HV- line 232 of the test cable 238. The fourteenth switch S14 is connected between the HV+ pin of the diagnosis charging inlet 236 and the first HV+ line 226 of the test cable 238.

The current to the diagnosis charging inlet 236 is supplied by the optional electric vehicle supply equipment 300 as described above. The diagnosis subcontroller 254 communicates by the CP and PP line with the charging controller 304 and 152(see figures 3). The CP line and PP line are passed through the test cable 238 connected to the CP pin and PP pin, respectively of the test plug 202. As soon as the diagnosis subcontroller 254 communicates with the charging controller 152 of the electric vehicle 100, the charging controller 152 connects the high voltage equipment 150 with the vehicle charging inlet 128 of the electric vehicle and charging is started.

Then, the measurements may be carried out as described above by the network analyzer 220, insulation testing device 216 and spectrum analyzer 218. These measurements will be described in further detail below. If the thirteenth switch S13 and fourteenth switch S14 are opened, the measurements may be carried out by a network analyzer 220, the insulation test device 216 and spectrum analyzer 218 after a load dump.

The test cable 238 comprises the first HV+ line 226 connected to the HV+ pin of the test plug 202 and a second HV+ line 228 connected to the HV+ pin of the test plug 202. The first HV+ line 226 is connected by a fourth fuse F4 to a twenty-second switch S22. The second HV+ line 228 is connected by a third fuse F3 with the twenty-first switch S21. The test cable 238 further comprises a first HV- line 230 connected by a second fuse F2 with a switch eighteenth switch S18 and a second HV- line 232 connected by a first fuse F1 with a fifteenth switch S15.

By a first path comprising the first fuse F1, the fifteenth switch S15, the first switch S1, a current measuring device I1 connected to the first switch S1, a first capacitor C1, a sixth switch S6, a twenty-second switch S22, the fourth fuse F4 an AC current measurement from the HV+ line 226 to the HV- line 232 is established. By a second path comprising the second fuse F2, an eighteenth switch S18, the third switch S3, a voltage measurement device V1, and a second capacitor C2, a fifth switch S5, a twenty-first switch S21 and a third fuse F3 an AC voltage measurement from second HV+ line 228 to first HV- line 230 is established. Thereby, a four-pole measurement is established.

As soon as the charging controller 152 connects the high voltage battery 102 of the high voltage equipment 150 with the HV+ pin and HV- pin of the vehicle charging inlet 128 of the electric vehicle 100, a voltage of approximately 400 V to approximately 800 V is applied between the HV+ lines 226, 228 and the HV- lines 230, 232. Therefore, the first capacitor C1 blocks the DC voltage for avoiding that a high voltage is applied to the network analyzer 220 coupled with the capacitors C1. The second capacitor C2 blocks the DC voltage from the voltage measurement device V1. Therefore, the current measurement device I1 connected to the first switch S1 and the voltage measurement device V1 only a measure the AC component of the current and voltage.

Before diagnosis can be performed the first capacitor C1 and second capacitor C2 have to be pre-charged such that they have the same voltage as between the HV+ line and HV- line. In a first embodiment the second switch S2 is closed and the first capacitor C1 is charged by the second resistor R2 connected between the second switch S2 and first capacitor C1. The second capacitor C2 is charged after closing the fourth switch S4. A fourth resistor R4 is interconnected between the first pin of the fourth switch S4 and second capacitor C2, wherein the second pin of the fourth switch S4 is connected with the eighteenth switch S18, the second fuse F2 and the first HV- line 230.

For pre-charging the first capacitor C1 the second switch S2, the sixth switch S6, the fifteenth switch S15 and the twenty-second S22 switch must be closed. For pre-charging the second capacitor C2 the fourth switch S4, the fifth switch S5, the eighteenth switch S18 and the twenty-first switch S21 must be closed. Current for pre-charging the first capacitor C1 and the second capacitor C2 is supplied by the high voltage battery 102 and/or electric vehicle supply equipment 300.

In the second embodiment first capacitor C1 may be pre-charged by an optional first DC voltage source P1 connected in parallel to the first capacitor C1. The second capacitor C2 may be pre-charged, if the fourth switch S4, fifth switch S5, eleventh switch S11 and twelfth switch S12 are closed. The eleventh switch S11 is interconnected between the first output of an optional second voltage source P2 and the fourth switch S4, and the twelfth switch S12 is connected between the second pin of the voltage source P2 and the fifth switch S5. The first voltage source P1 and the second voltage source P2 supply a voltage that corresponds with the voltage of the high voltage battery 102 of the electric vehicle 100.

In the first embodiment, the second switch S2 and the fourth switch S4 are opened, if the first capacitor C1 and the second first capacitor C2 are charged to a voltage corresponding to the voltage of the high voltage battery 102 of the vehicle.

In the second embodiment the fourth switch S4, the eleventh switch S11 and the twelfth switch S12 are opened, if the first capacitor C1 and the second first capacitor C2 are charged to a voltage corresponding to the voltage of the high voltage battery 102 of the vehicle.

After the first and second capacitor C1, C2 have been pre-charged to the voltage of the high voltage battery 102 of the electric vehicle, the first and second voltage sources P1, P2 are switched off.

Then, the actual diagnosis may be started. An AC source AC1 is connected serially to the first capacitor C1, which is connected serially to the current measurement device I1 and the first switch S1. A first pin of the second resistor R2 is connected to the first output of the AC source AC1, the first pin of the first capacitor C1 and the first pin of the first resistor R1. The second pin of the second resistor R2 is connected to the second switch S2.

The second pin of capacitor C1 is connected with the sixth switch S6, to which the twenty-second switch S22 is connected. The fourth fuse F4 connects the twenty-second switch S22 with the first HV+ line 226 of the test cable 238. The first fuse F1 connects the second HV- line 232 of the test cable 238 with the fifteenth switch S15.

For an impedance analysis, the first switch S1, the fifteenth switch S15, the sixth switch S6 and the twenty-second switch S22 are closed, and the AC source AC1 outputs an AC sweep signal in a predetermined frequency range, such as approximately 10 Hz to approximately 500 kHz.

A voltage measurement device V1 is connected parallel to a third resistor R3. The first input of the voltage measurement device V1 is connected to the third switch S3, which is connected by the eighteenth switch S18 and the second fuse F2 with the first HV- line 230 of the test cable 238. The second input of the voltage measurement device V1 is connected by the second capacitor C2 with the fifth switch S5, which is connected by the twenty-first switch S21 and the third fuse F3 with the second HV+ line 228 of the test cable 238.

The impedance of the high voltage equipment 150 can be determined by measuring the voltage over the second HV+ line 228 to the first HV- line 230 using the first voltage measurement device V1 and measuring the current through the first HV+ line 226 to the second HV- line 232 using the current measurement device I1. The result of the impedance analysis may be stored as a Bode diagram or as an impedance characteristic.

For measuring the impedance from HV+ to HV- the first switch S1, the third switch S3, the fifth switch S5, the sixth switch S6, the fifteenth switch S15, the eighteenth switch S18, the twenty-first switch S21 and the twenty second switch S22 are closed and the sixteenth switch S16, the seventeenth switch S17, the nineteenth switch S19 and the twentieth is switched S20 are opened. The sixteenth switch S16 is connected between a ground line 240 and the first switch S1 and the second switch S2. The ground line is also connected to the ground pin of the diagnosis charging inlet 236 and the ground pin of the test plug 202. The seventeenth switch S17 is connected to the third switch S3 and the fourth switch S4 and to a ground line 242, which is also connected to the ground pin of the test plug 202. The eighteenth switch S18 is connected with the first pin to the third switch S3 and the fourth switch S4, and connected with the second pin to the second fuse F2, which is connected to the first HV- line 230. The nineteenth switch S19 is connected with the first pin with the ground line 240 of the test cable 238 and with the second pin to the fifth switch S5. The first pin of the twentieth switch S20 is connected to the ground line 242, and a second pin of the twentieth switch S20 is connected with the twenty-second switch S22 and the sixth switch S6.

The impedance between HV+ and ground may be determined, if first switch S1, the third switch S3, the fifth switch S5, the sixth switch S6, the sixteenth switch S16, the seventeenth switch S17, the twenty-first switch S21 and the twenty-second switch S22 are closed, and the fifteenth switch S15, the eighteenth switch S18, the nineteenth switch S19 and the twentieth switch S20 are opened. The impedance between HV- and ground may be determined, if the first switch S1, the third switch S3, the fifth switch S5, the sixth switch S6, the fifteenth switch S15, the eighteenth switch S18, the nineteenth switch S19 and the twentieth switch S20 are closed and the the sixteenth switch S16, the seventeenth switch S17, the twenty-first switch S21 and the twenty-second switch S22 are opened.

The impedance analysis is an important indicator of the status of the high voltage equipment (high power power net) 150 of the electric vehicle 100. The impedance of the high voltage equipment 150 should not change during the lifecycle of the electric vehicle 100. The impedance of the high voltage equipment 150 may change due to an error, such as a short circuit, wrong assembly of components, aging of the high voltage battery 102 and/or the intermediate circuit capacitor or the like.

In one embodiment, the spectrum analyzer 218 may be connected in parallel to the AC source AC1. The spectrum analyzer may be carried out as described above in the context of the impedance analysis and the switches may be switched as described above in the context of the impedance analysis.

A second embodiment may comprise the spectrum analyzer 218', wherein the first output of the spectrum analyzer 218' is connected by a nineth switch S9 with the third switch S3, the fourth switch S4, the seventeenth switch S17 and the eighteenth switch S18. The second output of the spectrum analyzer S218' is connected by a tenth switch S10 with the fifth switch S5, the nineteenth switch S19 and the twenty-first switch S21.

In one embodiment the diagnosis subcontroller 254 may communicate with a charging controller 152 and request that the HV+ pin and HV- pin of the charging inlet 128 is connected with a predetermined component of the electric vehicle 100, such as the air-conditioning, heating, inverter, traction drive unit or the like. In this embodiment, the thirteenth switch S13 and the fourteenth switch S14 are opened, such that no high voltage is applied to the HV+ pin and HV- pin of the test plug 202. Then, the spectrum analyzer 218 or 218' will analyze the predetermined component connected with the HV+ pin and HV- pin of the charging inlet 128 of the electric vehicle 100. The spectrum analysis may be carried out as a passive analysis and no test input signal is transmitted to the electronic component to be analyzed.

In this case the AC source AC1 does not generate any pulses but the spectrum analyzer 218 connected parallel to the AC source AC1 or the spectrum analyzer 218' connect to the ninth switch S9 and the tenth switch S10 with the second HV+ line 228 and with the first HV- line 230 carries out the spectrum analysis. It is also possible to perform the spectrum analysis during charging the high voltage battery 102 of the electric vehicle 100. In this case the thirteenth switch S13 and the fourteenth switch S14 are closed and the first HV+ line 226 and the second HV- line 232 are connected with the electric vehicle supply equipment 300. If a vehicle to home and/or a vehicle to load function is available, it is also possible to perform a spectrum analysis of the vehicle to home current and/or vehicle to load current.

Before spectrum analysis the first capacitor C1 is pre-charged, by closing the second switch S2, the sixth switch S6, the fifteenth switch S15 and the twenty-second switch S22. When the first capacitor C1 is pre-charged, the second switch S2 is opened and the first switch S1 is closed. Then, first switch S1, the sixth switch S6, the fifteenth switch S15 and the twenty-second switch S22 are closed and the spectrum analyzer 218 measures the AC component of the current and/or voltage and analyzes the spectrum of the frequencies, such as by FFT.

The spectrum analyzer 218' must be rated for high voltage, since it is directly connected with the high voltage of the second HV+ line 228 and first HV- line 230. The spectrum analyzer 218' can analyze the spectrum of the voltage on the second HV+ line 228 and first HV- line 230, if the nineth switch S9, the tenth switch S10, the eighteenth switch S18 and the twenty-first S21 are closed.

Further, the insulation tester 216 allows diagnosing the insulation. In this case pre-charging of the first capacitor C1 and the second capacitor C2 is not necessary. The insulation tester 216 allows determining the insulation from HV+ to HV-, HV+ to ground and HV- to ground. If the thirteenth switch S13 and the fourteenth switch S14 are closed, the insulation resistance of the whole system is determined including the electric vehicle supply equipment 300 connected to the diagnosis charging inlet 236.

A first pin of the insulation tester 216 is connected to a first pin of a seventh switch S7, and the second pin of the seventh switch S7 is connected to the third switch S3, the fourth switch S4, the seventeenth switch S17 and the eighteenth switch S18. The second pin of the insulation tester 216 is connected with a first pin of the eighth switch S8, and the second pin of the eighth switch S8 is connected with the fifth switch S5, the nineteenth switch S19 and the twenty-first switch S21.

The ground line 240 is directly connected to the third pin of the insulation tester 216. The second HV+ line 228 is connected by the third fuse F3, the twenty-first switch S21 and an eighth switch S8 with the second pin of the insulation tester 216. The first HV- line 230 by the second fuse F2, the eighteenth S18 and a seventh switch S7 with the third pin of the insulation tester 216. By appropriate switching of the seventh switch S7, the eighth switch S8, the eighteenth S18 and twenty-first switch S21 the insulation resistance between HV+ to HV-, HV+ to ground and HV- to ground may be determined.

A first bi-directional suppressor diode D1 is connected in parallel with the first AC source AC1. A second bi-directional suppressor diode D2 is connected in parallel to the first voltage measurement device V1.

The vehicle test apparatus 200 further comprises a calibration connector 260 in which the plug 202 of the vehicle test cable may be plugged. A fifth resistor R5 is connected serially with a twenty-third switch S23 between the HV+ pin and HV- of the calibration connector 260. A sixth resistor R6 is connected serially with a twenty-fourth switch S24 between the HV+ pin and HV- of the calibration connector 260. By closing the twenty-third switch S23 and/or the twenty-fourth switch S24 the insulation tester 216 may be calibrated by the known values or the fifth resistor R5 or sixth resistor R6 or by the resistance value of the fifth resistor R5 or sixth resistor R6 connected in parallel.

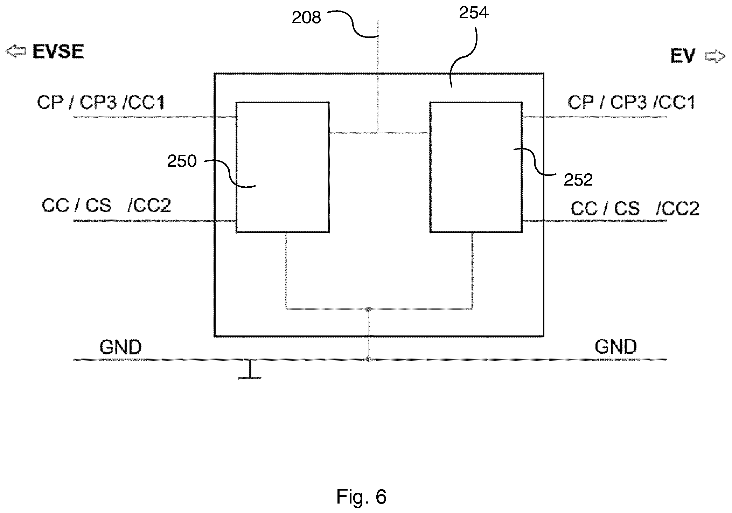

Reference is made to figure 6 showing the diagnosis subcontroller 254 more detailed. An electric vehicle control and connection emulator 250 communicates via the CP/CP3/CC1 and CC/CS/CC2 lines with the electric vehicle supply equipment 300. The electric vehicle control and connection emulator 250 is connected to an electric vehicle supply equipment control and connection emulator 252 that communicates with the electric vehicle 100 by the CP/CP3/CC1 and CC/CS/CC2 lines. An interface 208 for transmitting control data to the diagnosis subcontroller 254 is connected with the electric vehicle control and connection emulator 250 and the electric vehicle supply equipment control and connection emulator 252. The electric vehicle supply equipment control and connection emulator 252 emulates the communication with the charging controller 152 (see figure 3) of the electric vehicle 100. The electric vehicle control and connection emulator 250 emulates the communication with the charging controller 304 of the electric vehicle supply equipment 300.

The electric vehicle control and connection emulator 250 comprises essentially the same circuit which is generally in the charging inlet 128 of the electric vehicle 100 and the charging controller 152 of the electric vehicle 100. The electric vehicle supply equipment control and connection emulator 252 comprises essentially the same circuit as that is installed in charging plug 302 and charging controller 304 of the electric vehicle supply equipment 300.

The present invention has the advantage that electronic components of an electric vehicle 100 can be diagnosed with a low effort.

## Claims

1. A method of diagnosing an electric component of an electric vehicle comprising a high voltage traction battery and a charging connector coupled with the high voltage traction battery, comprising the following steps:
- connecting a vehicle test apparatus with the charging connector of the electric vehicle by a test cable;
- verifying the at least one electric component of the electric vehicle;
- wherein the step of verifying comprises the following step:
- receiving the monitoring signal of the electric component at the vehicle test apparatus, wherein the monitoring signal is transmitted via the charging connector and the test cable; or comprises the following two steps:
- transmitting a test input signal from the vehicle test apparatus via the test cable and the charging connector to the electric component of the electric vehicle;
- receiving the monitoring signal of the electric component responsive to the test input signal at the vehicle test apparatus, wherein the monitoring signal is transmitted via the charging connector and the test cable; and
- analyzing the monitoring signal at the vehicle test apparatus.

2. The method of claim 1, wherein the test input signal comprises at least one of the following:
- an impedance measurement signal; and
- and
- an isolation measurement signal; and
wherein the monitoring signal comprises at least one of the following:
- an impedance measurement signal;
- a spectrum analysis signal; and
- an isolation measurement signal.

3. The method of claim 1 or 2, further comprising the following step:
- supplying charging current for charging a high voltage traction battery to the charging connector, wherein the charging current flows through the test cable.

4. The method of any one of claims 1 to 3, further comprising the following steps before the step of supplying charging current:
- transmitting a charging request command from the vehicle test apparatus via the test cable and the charging connector to a charging controller of the electric vehicle;
- closing at least one charging switch of the electric vehicle responsive to the charging request command under control of the charging controller, wherein the charging switch connects at least one pin of the charging connector with the high voltage traction battery of the electric vehicle; and
- after detecting at the vehicle test apparatus that charging current flows through the test cable executing the step of verifying the at least one electric component of the electric vehicle.

5. The method of any one of claims 1 to 4, further comprising the following steps:
- transmitting a charging request command from the vehicle test apparatus via the test cable and the charging connector to the charging controller of the electric vehicle;
- closing at least one charging switch of the electric vehicle responsive to the charging request command under control of the charging controller, wherein the charging switch connects at least one pin of the charging connector with the high voltage traction battery of the electric vehicle; and
- after detecting at the vehicle test apparatus that charging current flows through the test cable for a predetermined time span stopping the charging current from the vehicle test apparatus to the test cable by opening a charging switch in the vehicle test apparatus and then executing the step of verifying the at least one electric component of the electric vehicle.

6. The method according to any one of claims 1 to 5, comprising the following step before verifying the at least one electric component of the electric vehicle:
- transmitting a connection request signal from the vehicle test apparatus to a vehicle diagnosis controller via the test cable, wherein the connection request signal requests that the vehicle test apparatus is to be connected to a predetermined component of the electric vehicle and wherein the vehicle diagnosis controller connects at least one pin of the charging connector with the predetermined component of the electric vehicle.

7. The method according to claim 6, further comprising the following step before the step of verifying the at least one electric component of the electric vehicle:
- transmitting a status change request signal from the vehicle test apparatus to the vehicle diagnosis controller via the test cable, wherein the status change request signal requests that the predetermined component of the electric vehicle is switched into a predetermined status and wherein the vehicle diagnosis controller switches the predetermined component of the electric vehicle in the predetermined status.

8. A vehicle test apparatus for diagnosing an electric component of an electric vehicle comprising a high voltage traction battery and a charging connector coupled with the high voltage traction battery, wherein the vehicle test apparatus comprises:
- a cable connection element adapted that a test cable can be connected thereto, wherein the test cable comprises a test plug that can be coupled to a charging connector of the electric vehicle;
- a first controller adapted to verify at least one electric component of the electric vehicle;
- a transmitter adapted to transmit a test input signal via the test cable and the charging connector to the electric component of the electric vehicle;
- a receiver adapted to receive a monitoring signal of the electric component responsive to the test input signal, wherein the monitoring signal is transmitted via the charging connector and the test cable; and
- an analyzer adapted to analyze the monitoring signal
wherein the first controller is further adapted to the following for verifying at least one electric component of the electric vehicle:
- instructing a receiver to receive a monitoring signal of the electric component responsive to the test input signal, wherein the monitoring signal is transmitted via the charging connector and the test cable; or
- instructing a transmitter to transmit a test input signal via the test cable and the charging connector to the electric component of the electric vehicle; instructing the receiver to receive a monitoring signal of the electric component responsive to the test input signal, wherein the monitoring signal is transmitted via the charging connector and the test cable.

9. The vehicle test apparatus according to claim 8, wherein the test input signal comprises at least one of the following:
- an impedance measurement signal; and
- an isolation measurement signal; or
wherein the monitoring signal comprises at least one of the following:
- an impedance measurement signal;
- a spectrum analysis signal; and
- an isolation measurement signal.

10. The vehicle test apparatus according to claim 8 or 9, further comprising
- charging device adapted to supply a charging current to the charging connector of the electric vehicle to charge the high voltage traction battery, wherein the charging current flows through the test cable.

11. The vehicle test apparatus according to claim 10, further comprising a first test controller adapted to
- transmit a charging request command via the test cable and the charging connector to a charging controller of the electric vehicle, wherein the charging controller of the electric vehicle is adapted to close at least one charging switch of the electric vehicle responsive to the charging request command, wherein the charging switch connects at least one pin of the charging connector with the high voltage traction battery of the electric vehicle; and
- verifying the at least one electric component of the electric vehicle.

12. The vehicle test apparatus according to claim 10 or 11, wherein the first test controller is further adapted to
- transmit a charging request command via the test cable and the charging connector to the charging controller of the electric vehicle, wherein the charging controller of the electric vehicle is adapted to close at least one charging switch of the electric vehicle responsive to the charging request command, wherein the charging switch connects at least one pin of the charging connector with the high voltage traction battery of the electric vehicle; and
- stopping the charging current flow from the vehicle test apparatus to the test cable by opening a charging switch of the vehicle test apparatus after detecting at the vehicle test apparatus that charging current flows through the test cable for a predetermined time span and then verifying the at least one electric component of the electric vehicle.

13. The vehicle test apparatus according to any one of claims 8 to 12, further comprising a second test controller adapted to
- transmitting a connection request signal to a vehicle diagnosis controller via the test cable, wherein the connection request signal requests that the vehicle test apparatus is to be connected to a predetermined electric component of the electric vehicle and wherein the vehicle diagnosis controller connects at least one pin of the charging connector with the predetermined component of the electric vehicle; and
- verifying the at least one electric component of the electric vehicle.

14. The vehicle test apparatus according to claim 13, wherein the second test controller is adapted to
- transmit a status change request signal to the vehicle diagnosis controller via the test cable, wherein the status change request signal requests that the predetermined component of the electric vehicle is switched into a predetermined status and wherein the vehicle diagnosis controller is adapted to switch the predetermined component of the electric vehicle in the predetermined status.

15. An electric vehicle, comprising:
- a high voltage traction battery;
- a charging connector that can be connected with the high voltage traction battery;
- at least one further electric component; and
- a vehicle diagnosis controller adapted to, after receiving a connection request signal at at least one pin of the charging connector, to control at least one diagnosis switch such that at least one pin of the charging connector is connected with the at least one further electric component.
